# EUROPEAN PATENT APPLICATION

(11) **EP 2 378 389 A2**
(43) Date of publication of application: **19.10.2011**
(21) Application number: 10167727.6
(22) Date of filing: 29.06.2010
(51) Int. Cl.: G06F 1/20

(54) **Heat dissipation system and heat dissipation method**

(30) Priority: 14.04.2010 TW 99111611
(71) Applicant: Acer Incorporated, Hsichih, Taipei Hsien 221 (TW)
(72) Inventor: Huang, I-Huei, Hsichih Taipei Hsien 221 Taiwan, ROC (TW)
(74) Representative: Chamberlain, Alan James

(57) **Abstract**

A heat dissipation system suited for dissipating heat of a heat source. The heat dissipation system includes at least one flow channel, at least one electrode pair, and a control unit. The flow channel passing through the heat source has at least two openings. The electrode pair disposed in the flow channel is near the openings. The control unit is electrically connected to the electrode pair to control the voltage of the electrode pair, so that the electrode pair is discharged to ionize the air nearby, and to produce an ionized flow in the flow channel. The control unit controls a polarity and a magnitude of the voltage of the electrode pair to change the direction and the speed of the ionized flow, so that the ionized flow flows out of or into the flow channel from at least one of the openings. A heat dissipation method is also provided.

## Description

### BACKGROUND OF THE INVENTION

### 1. Field of the Invention

The present invention generally relates to a heat dissipation system and a heat dissipation method. More particularly, the present invention relates to a heat dissipation system of an electronic device and a heat dissipation method.

### 2. Description of Related Art

Electronic elements, such as a central processing unit (CPU) of a computer, of an electronic device generate heat while the electronic device is operating. For preventing an inner temperature of the electronic device from being too high due to the accumulating of heat, a heat dissipation device suitable of dissipating heat is needed. Taking a computer for example, current heat dissipation device generates an air convection effect in an electronic device by a fan to dissipate heat of the electronic device directly, or to dissipate heat of heat pipes or fins for the hot air in an electronic product to flow out of the electronic product.

However, current electronic devices are developed with a trend toward being light, low profile, small and convenient to carry. Thus, the volume of a fan causes a great effect in an electronic device. Therefore, solving the above-mentioned problem and providing a heat dissipation method more flexible are worth thinking over.

### SUMMARY OF THE INVENTION

The present invention is to provide a heat dissipation system with smaller operation space.

The present invention is to provide a heat dissipation method with greater practicability.

As embodied and broadly described herein, the present invention provides a heat dissipation system suitable for dissipating heat of at least one heat source. The heat dissipation system includes at least one flow channel, at least one electrode pair and a control unit. The flow channel passes through the heat source and having at least two openings. The electrode pair is disposed in the flow channel and next to one of the openings. The control unit is electrically connected to the electrode pair to control the voltage of the electrode pair, such that the electrode pair is discharged to ionize the air near the electrode pair for producing an ionized flow in the flow channel, wherein the control unit controls a polarity and a magnitude of the voltage of the electrode pair to change a direction and a speed of the ionized flow, such that the ionized flow flows out of the flow channel or flows into the flow channel from at least one of the openings.

As embodied and broadly described herein, the present invention provides a heat dissipation method suitable for dissipating heat of an electronic device. The electronic device includes at least one heat generating element disposed in a casing of the electronic device and at least one electrode pair disposed at at least one opening of the casing. The electronic device further includes a control unit suitable for controlling a polarity and a magnitude of a voltage provided to the at least one electrode pair. The heat dissipation method includes detecting a temperature of the heat generating element, and deciding the polarity and the magnitude of the voltage provided to the at least one electrode pair according to the temperature.

As embodied and broadly described herein, the present invention provides a heat dissipation method suitable for dissipating heat of an electronic device. The electronic device includes a plurality of heat generating elements disposed in a casing of the electronic device and a plurality of electrode pairs disposed at the openings of the casing respectively. The electronic device further includes a control unit suitable for controlling a polarity and a magnitude of a voltage provided to the electrode pairs. The heat dissipation method includes detecting a temperature of each of the heat generating elements and transferring the temperature of each of the heat generating elements to the control unit, and deciding a provided voltage provided to each of the electrode pairs according to the temperature of each of the heat generating elements, such that at least one ionized flow passing through each of the heat generating elements is formed. The control unit is capable of changing a polarity and a magnitude of the provided voltage of each of the electrode pairs for changing a speed of the ionized flow or changing a direction of the ionized flow.

According to an embodiment of the present invention, the heat dissipation system further includes a sensor disposed in the flow channel for detecting a temperature in the flow channel, wherein the sensor is electrically connected to the control unit, such that the control unit controls the polarity and the magnitude of the voltage of the electrode pair according to the temperature.

According to an embodiment of the present invention, the at least two openings includes an inlet and an outlet, wherein the electrode pair is disposed at the outlet.

According to an embodiment of the present invention, the at least one flow channel includes a plurality of flow channels, the flow channels have a plurality of openings, the at least one electrode pair includes a plurality of electrode pairs disposed at the corresponding openings, and the control unit is electrically connected to the electrode pairs.

In summary, in the present invention, the electrode pair is disposed in the flow channel of the heat dissipation system, such that the ionized flow is formed by the high-voltage discharging of the electrode pair for dissipating heat. Thus, space occupying and channel planning problem due to using a fan as a power source of air flowing are solved, such that the electronic device can be lighter, lower profile, smaller and more convenient to carry while a heat dissipation ability of the electronic device is maintained. Furthermore, on the basis of the heat dissipation method of the above-mentioned embodiment, a designer is able to arrange the flow channel passing through the heat sources according to different conditions of the inner of the electronic device, while the speed and the direction of the ionized flow in the flow channel are controlled by controlling the polarity and the magnitude of the voltage of the electrode pair, such that a heat dissipation effect of the heat dissipation system is promoted.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.

Fig. 1 is a schematic view showing an electronic device according to one embodiment of the present invention.

Fig. 2 is a block diagram illustrating connecting of circuits in the electronic device.

Fig. 3A is a partially top view of the electronic device of Fig. 1.

Fig. 3B is a partially top view of a third opening of an electronic device according to another embodiment of the present invention.

Fig. 4A to Fig. 4C respectively illustrating a polarity distribution of an electrode pair during a continuous time period.

Fig. 5 is a flowchart illustrating a heat dissipation method according to one embodiment of the present invention.

Fig. 6 is a flowchart illustrating a heat dissipation method according to another embodiment of the present invention.

### DESCRIPTION OF THE EMBODIMENTS

Reference will now be made in detail to the present embodiments of the invention, examples of which are illustrated in the accompanying drawings. Wherever possible, the same reference numbers are used in the drawings and the description to refer to the same or like parts.

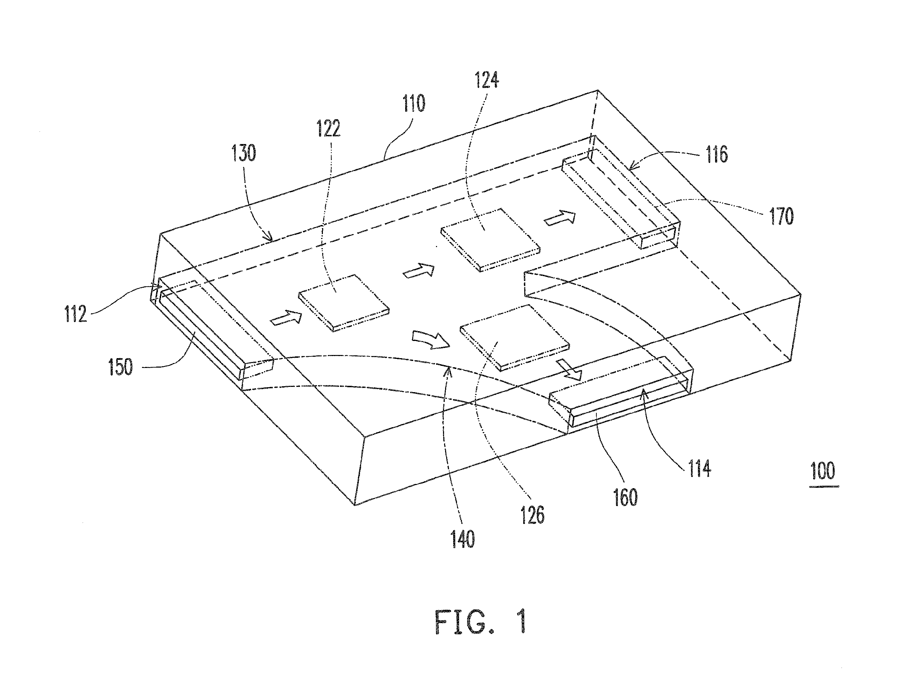

Fig. 1 is a schematic view showing an electronic device according to one embodiment of the present invention. Referring to Fig. 1, the electronic device 100 of the embodiment includes a casing 110 and a plurality of electronic elements 122, 124 and 126 disposed in the casing 110. In the embodiment, the electronic device 100 is, for example, a main frame of a notebook computer, and the electronic elements 122, 124 and 126 are, for example, a CPU or a graphic chip. Because of great promotion of integration degree and operation speed of these electrical circuits, it is necessary to face the heat dissipation problem of the electronic device.

Accordingly, the electronic device 100 further includes a first flow channel 130 and a second flow channel 140 for connecting a first opening 112, a second opening 114 and a third opening 116 located on a surface of the casing 110. In the embodiment, the first flow channel 130 and the second flow channel 140 respectively pass through electronic elements 122, 124 and 126 or pass through heat dissipation fins or heat pipes (not shown) disposed next to the electronic elements 122, 124 and 126. In addition, the electronic device 100 further includes a first electrode pair 150, a second electrode pair 160 and a third electrode pair 170 disposed respectively at the three opening 112, 114 and 116.

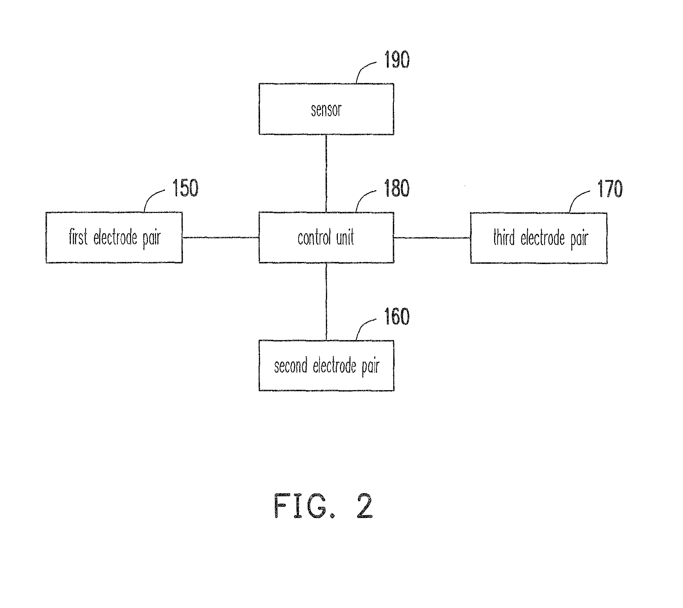

Fig. 2 is a block diagram illustrating connecting of circuits in the electronic device. Referring to Fig.1 and Fig. 2, in the embodiment, the electrode pairs 150, 160 and 170 are electrically connected to a control unit 180 for the control unit 180 to be suitable of providing voltage to the electrode pairs 150, 160 and 170, such that the electrode pairs 150, 160 and 170 is capable of performing high-voltage discharging to ionize the air near the electrode pairs 150, 160 and 170. Thus, an ionized flow (shown as arrowheads in Fig. 1) is formed in the flow channels 130 and 140 by the electrode pairs 150, 160 and 170, and heat of the electronic elements 122, 124 and 126 (or heat dissipation fins or heat pipes disposed on the electronic elements 122, 124 and 126) is dissipated by flowing of the ionized flow in the flow channel 130 and 140. In the embodiment, the control unit 180 is, for example, disposed on a control chip or a control circuit in the electronic device 100.

Further, in the embodiment, the high voltage provided to the electrode pairs 150, 160 and 170 by the control unit 180 while the electrode pairs 150, 160 and 170 are discharging is suitable of being provided from a liquid crystal display screen of the electronic device 100. However, the type of the control unit 180 and the high voltage source of the control unit 180 are not limited in the embodiment.

Referring to Fig. 1 again, the control unit 180 controls the third electrode pair 170 located at the third opening 116 to perform high-voltage discharging, such that the air near the third opening 116 is ionized to form a difference of air density for the air in the first flow channel 130 to flow toward the third opening 116. Similarly, the control unit 180 controls the second electrode pair 160 located at the second opening 114 to perform high-voltage discharging, such that the air in the second flow channel 140 flows toward the second opening 114.

Thus, the air in the first flow channel 130 in the casing 110 and the air in the second flow channel 140 in the casing 110 flow toward the second opening 114 and toward the third opening 116 respectively from the first opening 112. In other words, the first opening 112 is disposed as an air inlet, and the second opening 114 and the third opening 116 are disposed as air outlets, such that a goal of dissipating heat of the electronic elements 122, 124 and 126 is achieved.

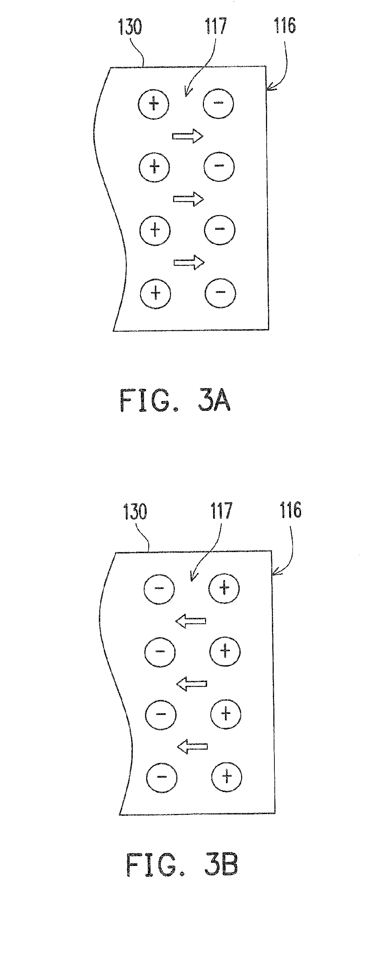

In the embodiment, a user is able to increase the voltage provided to the electrode pair 150, 160 or 170 for promoting the discharging effect of the electrode pair 150, 160 or 170, such that a speed of the ionized flow in the flow channel 130 and 140 is increased. Further, Fig. 3A is a partially top view of the electronic device of Fig. 1, and Fig. 3B is a partially top view of a third opening of an electronic device according to another embodiment of the present invention. Comparing Fig. 3A and Fig. 3B, similarly, the ionized flows in Fig. 3A and Fig. 3B are shown as arrowheads. When the polarity distribution of the third electrode pair 170 is changed from Fig. 3A to Fig. 3B by the control unit 180, a direction of the ionized flow in the first flow channel 130 is changed accordingly. This changing of a direction of an ionized flow also can be performed on the first electrode pair 160 and the second electrode pair 170.

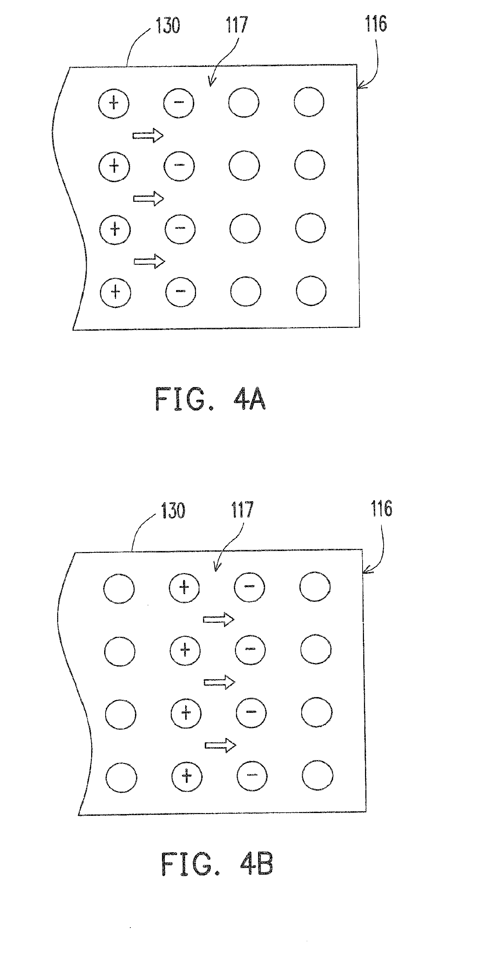

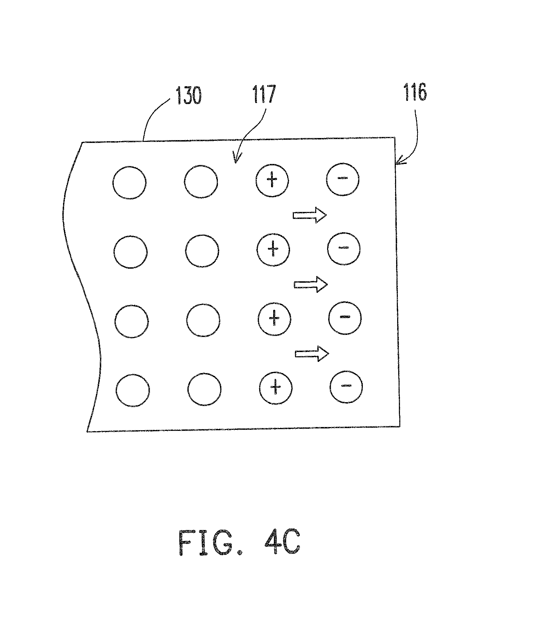

On the other hand, Fig. 4A to Fig. 4C respectively illustrating a polarity distribution of an electrode pair during a continuous time period. Referring to Fig. 4A to Fig. 4C, in the embodiment, the polarity distribution of the third electrode pair 170 is suitable of being changed by the control unit 180 during a continuous time period in sequence, such that a speed of the ionized flow nearby is increased. Therefore, a flow rate of the ionized flow in the flow channel 130 and 140 is increased, such that the heat dissipation effect acted on the electronic elements 122, 124 and 126 is promoted. Thus, the control unit 180 in the embodiment is able to change a direction and a speed of the ionized flow by controlling a polarity and a magnitude of the voltage of the electrode pairs 150, 160 and 170.

Referring to Fig. 1 again, for promoting the heat dissipation effect of the electronic device 100, the electronic device 100 further includes a sensor 190 disposed in the first flow channel 130 for detecting a temperature of an air flow in the first flow channel 130. The sensor 190 is electrically connected to the control unit 180, such that the control unit 180 is able to change a polarity and a magnitude of the voltage of the electrode pairs 150, 160 and 170 according to the temperature detected by the sensor 190. Thus, flow fields in the first flow channel 130 and the second flow channel 140 is able to be changed for promoting the heat dissipation effect.

The position of the sensor 190 in the flow channel 130 and 140 is not limited in the embodiment. In another embodiment of the present invention that is not shown in the drawings, a plurality of sensors can be disposed in the flow channel and next to the electronic elements respectively. Thus, the control unit is able to receive the variation of the temperature of each electronic element by the sensors and change a polarity and a magnitude of the voltage of the electrode pair at any time, such that a heat dissipation effect acting on the electronic device by the ionized flow in the flow channel is able to be adjusted according to a variation of the temperature of the electronic elements.

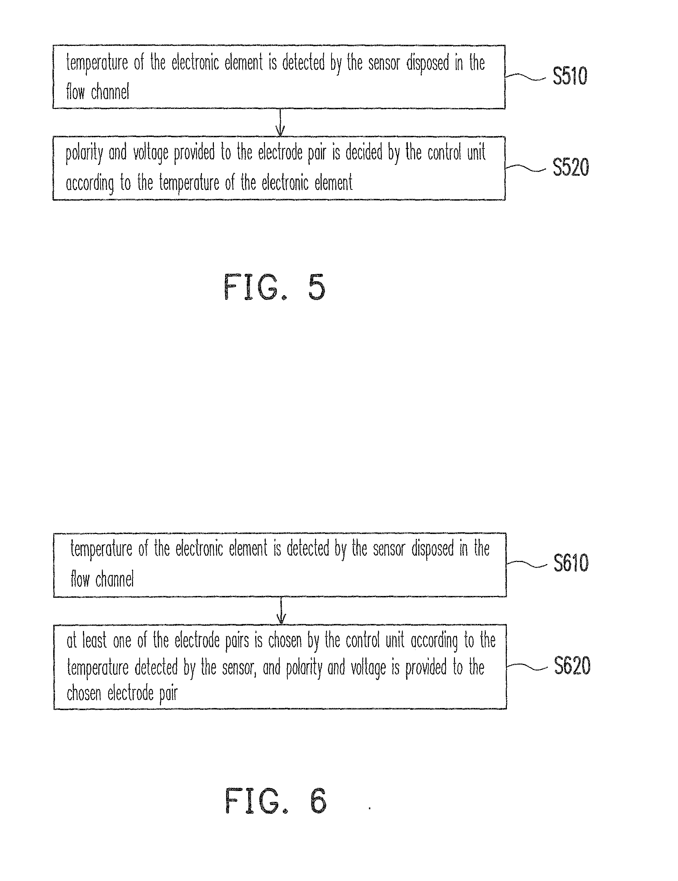

Fig. 5 is a flowchart illustrating a heat dissipation method according to one embodiment of the present invention. Referring to Fig. 1 and Fig. 5, in the embodiment, the heat dissipation method is suitable for promoting the heat dissipation effect acted on a plurality of electronic elements 122, 124 and 126 in the electronic device 100, wherein the related components has been described in the above-mentioned embodiment and will not be described again here. Herein, only one disposing manner of numerous embodiments is shown in the drawing, wherein the number of the flow channel 130 and 140 and the disposing manner of the flow channel 130 and 140 in the casing 110 are according to the positions of the electronic elements 122, 124 and 126 in the casing 110.

First, in the step S510, temperature of the electronic element 122, 124 and 126 is detected by the sensor 190 disposed in the flow channel 130 or 140.

Then, in the step S520, polarity and voltage provided to the electrode pair 150, 160 and 170 is decided by the control unit 180 according to the temperature of the electronic elements 122, 124 and 126. It should be noted that, according to the variation of the temperature, the control unit is able to change the provided voltage and polarity of each electrode pair, such that a flow rate of the ionized flow is increased or decreased or a direction of the ionized flow is changed. Thus, the control unit 180 is able to control the ionized flow generated in the flow channels 130 and 140 by the electrode pairs 150, 160 and 170 to pass through the electronic elements 122, 124 and 126, such that a heat dissipation effect is performed. In addition, the control unit 180 is able to change a direction and a speed of the ionized flow according to the temperature detected by the sensor 190 at any time, such that the heat dissipation effect is promoted.

Fig. 6 is a flowchart illustrating a heat dissipation method according to another embodiment of the present invention. Referring to Fig. 6, the difference between the embodiment in Fig. 6 and the embodiment in Fig. 5 is, in the step S620, at least one of the electrode pairs 150, 160 and 170 is chosen by the control unit 180 according to the temperature detected by the sensor 190, and polarity and voltage is provided to the chosen electrode pair. In other words, in the embodiment, the electrode pairs 150, 160 and 170 in the first flow channel 130 and the second flow channel 140 are not operated at any time. The control unit 180 is able to judge whether the electronic elements 122, 124 and 126 reach the standard of heat dissipation or not.

For example, if the electronic elements 122 and 124 are generating large heat because of being operated persistently while the electronic element 126 is not reaching the standard of heat dissipation, the control unit 180 only controls the first electrode pair 150 or the third electrode pair 170 to perform high-voltage discharging. Thus, the ionized flow in the first flow channel 130 will flow toward the first opening 112 and the third opening 116 respectively, and the ionized flow in the second flow channel 140 will flow toward the first flow channel 130. In other words, the first opening 112 and the third opening 116 are regarded as outlets of the ionized flow at this condition, and outer air will flow into the second flow channel 140 through the second opening 114. Thus, the heat dissipation method of the present invention is able to be arranged optimally according to the positions of the electronic elements 122, 124 and 126 and according to the heat generated by the operation of the electronic elements 122, 124 and 126. In addition, the heat dissipation method of the above-mentioned embodiments is not affected by the inner structure or space of an electronic device, such that the heat dissipation effect of the electronic device 100 is promoted.

In summary, in the present invention, the electrode pair is disposed in the flow channel, such that the ionized flow is formed by the high-voltage discharging of the electrode pair for dissipating heat of the electronic device. Thus, space occupying and channel planning problem due to using a fan as a power source of air flowing are solved, such that the electronic device can be lighter, lower profile, smaller and more convenient to carry while a heat dissipation ability of the electronic device is maintained. Furthermore, on the basis of the heat dissipation method of the above-mentioned embodiment, a designer is able to arrange the flow channel passing through the heat sources according to different conditions of the inner of the electronic device, while the speed and the direction of the ionized flow in the flow channel are controlled by controlling the polarity and the magnitude of the voltage of the electrode pair, such that a heat dissipation effect of the heat dissipation system is promoted.

It will be apparent to those skilled in the art that various modifications and variations may be made to the structure of the present invention without departing from the scope or spirit of the invention. In view of the foregoing, it is intended that the present invention cover modifications and variations of this invention provided they fall within the scope of the following claims and their equivalents.

## Claims

1. A heat dissipation system, suitable for dissipating heat of at least one heat source, the heat dissipation system comprising:
at least one flow channel (130, 140), passing through the heat source and having at least two openings (112, 114, 116);
at least one electrode pair (150, 160, 170), disposed in the flow channel (130, 140) and next to one of the openings (112, 114, 116); and
a control unit (180), electrically connected to the electrode pair (150, 160, 170) to control a voltage of the electrode pair (150, 160, 170), such that the electrode pair (150, 160, 170) is discharged to ionize the air near the electrode pair (150, 160, 170) for producing an ionized flow in the flow channel (130, 140), wherein the control unit (180) controls a polarity and a magnitude of the voltage of the electrode pair (150, 160, 170) to change a direction and a speed of the ionized flow, such that the ionized flow flows out of the flow channel (130, 140) or flows into the flow channel (130, 140) from at least one of the openings (112, 114, 116).

2. The heat dissipation system as claimed in claim 1, further comprising a sensor (190) disposed in the flow channel (130, 140) for detecting a temperature in the flow channel (130, 140), wherein the sensor (190) is electrically connected to the control unit (180), such that the control unit (180) controls the polarity and the magnitude of the voltage of the electrode pair (150, 160, 170) according to the temperature.

3. The heat dissipation system as claimed in claim 1, wherein the at least two openings (112, 114, 116) comprises an inlet and an outlet, wherein the electrode pair (150, 160, 170) is disposed at the outlet.

4. The heat dissipation system as claimed in claim 1, wherein the at least one flow channel (130, 140) comprises a plurality of flow channels (130, 140), the flow channels (130, 140) have a plurality of openings (112, 114, 116), the at least one electrode pair (150, 160, 170) comprises a plurality of electrode pairs (150, 160, 170) disposed at the corresponding openings (112, 114, 116), and the control unit (180) is electrically connected to the electrode pairs (150, 160, 170).

5. A heat dissipation method, suitable for dissipating heat of an electronic device (100), the electronic device (100) comprises at least one heat generating element (122, 124, 126) disposed in a casing (110) of the electronic device (100) and at least one electrode pair (150, 160, 170) disposed at at least one opening (112, 114, 116) of the casing (110), the electronic device (100) further comprises a control unit (180) suitable for controlling a polarity and a magnitude of a voltage provided to the at least one electrode pair (150, 160, 170), the heat dissipation method comprising:
detecting (S510, S610) a temperature of the heat generating element (122, 124, 126); and
deciding (S520) the polarity and the magnitude of the voltage provided to the at least one electrode pair (150, 160, 170) according to the temperature.

6. The heat dissipation method as claimed in claim 5, wherein the electronic device (100) further comprises a sensor (190) disposed in the casing (110), the control unit (180) is electrically connected to the sensor (190), and the heat dissipation method further comprising:
changing the polarity and the magnitude of the voltage provided to the electrode pair (150, 160, 170) by the control unit (180) according to the temperature detected by the sensor (190).

7. The heat dissipation method as claimed in claim 6, wherein the at least one electrode pair (150, 160, 170) comprises a plurality of electrode pairs (150, 160, 170), the at least one opening (112, 114, 116) comprises a plurality of openings (112, 114, 116), the electrode pairs (150, 160, 170) are disposed at the openings (112, 114, 116) correspondingly, and the heat dissipation method further comprising:
choosing (S620) at least one of the electrode pairs (150, 160, 170) by the control unit (180) according to the temperature detected by the sensor (190) for providing the voltage with the polarity and the magnitude.

8. A heat dissipation method, suitable for dissipating heat of an electronic device (100), the electronic device (100) comprises a plurality of heat generating elements (122, 124, 126) disposed in a casing (110) of the electronic device (100) and a plurality of electrode pairs (150, 160, 170) disposed at the openings (112, 114, 116) of the casing (110) respectively, the electronic device (100) further comprises a control unit (180) suitable for controlling a polarity and a magnitude of a voltage provided to the electrode pairs (150, 160, 170), the heat dissipation method comprising:
detecting (S510, S610) a temperature of each of the heat generating elements (122, 124, 126) and transferring the temperature of each of the heat generating elements (122, 124, 126) to the control unit (180); and
deciding (S520) a provided voltage provided to each of the electrode pairs (150, 160, 170) according to the temperature of each of the heat generating elements (122, 124, 126), such that at least one ionized flow passing through each of the heat generating elements (122, 124, 126) is formed,
wherein, the control unit (180) is capable of changing a polarity and a magnitude of the provided voltage of each of the electrode pairs (150, 160, 170) for changing a speed of the ionized flow or changing a direction of the ionized flow.

9. The heat dissipation method as claimed in claim 8, wherein the electronic device (100) further comprises a plurality of sensors (190) corresponding to the heat generating elements (122, 124, 126) respectively, the control unit (180) is electrically connected to the sensors (190), and the heat dissipation method further comprising:
after detecting the temperature of each of the heat generating elements (122, 124, 126), changing the polarity and the magnitude of the voltage provided to the electrode pair (150, 160, 170) by the control unit (180) according to the temperature detected by the sensor (190).

10. The heat dissipation method as claimed in claim 9, further comprising:
choosing (S620) at least one of the electrode pairs (150, 160, 170) by the control unit (180) according to the temperature detected by the sensor (190) for providing the voltage with the polarity and the magnitude.
